Europäisches Patentamt

European Patent Office

Office européen des brevets

(19)

(11) Veröffentlichungsnummer: **0 212 307 B1**

(12) **EUROPÄISCHE PATENTSCHRIFT**

(45) Veröffentlichungstag der Patentschrift: **25.03.92**

(51) Int. Cl.⁵: **H02J 13/00**, H03H 17/00

(21) Anmeldenummer: **86110113.7**

(22) Anmeldetag: **23.07.86**

(54) **Rundsteuerempfänger.**

(30) Priorität: **05.08.85 DE 3528046**

(43) Veröffentlichungstag der Anmeldung:
**04.03.87 Patentblatt 87/10**

(45) Bekanntmachung des Hinweises auf die
Patenterteilung:
**25.03.92 Patentblatt 92/13**

(84) Benannte Vertragsstaaten:
**AT BE CH DE FR GB IT LI NL SE**

(56) Entgegenhaltungen:
**EP-A- 0 105 087**
**DE-A- 2 338 620**
**FR-A- 2 381 407**

**IEEE TRANS. ON COMMUNICATIONS, vol.
COM-33, Nr. 10, Oktober 1985, Seiten
1117-1125, IEEE, New York, US; N. BENVENU-
TO et al.: "Realization of finite impulse response filters using coefficients +1, 0, and
-1"**

(73) Patentinhaber: **Asea Brown Boveri Aktiengesellschaft
Kallstadter Strasse 1
W-6800 Mannheim-Käfertal(DE)**

(72) Erfinder: **Kronmüller, Heinz, Prof.Dr.Ing.
Steinhofstrasse 48
W-7500 Karlsruhe 41(DE)**
Erfinder: **Stöckle, Joachim, Dipl.-Ing.
Lindenweg 1
W-7513 Stutensee-Büchig(DE)**
Erfinder: **Pühler, Jörg, Dipl.-Ing.
Nuitstrasse 19
W-7500 Karlsruhe 1(DE)**

(74) Vertreter: **Rupprecht, Klaus, Dipl.-Ing. et al
c/o Asea Brown Boveri Aktiengesellschaft
Zentralbereich Patente Postfach 100351
W-6800 Mannheim 1(DE)**

**Beschreibung**

Die Erfindung bezieht sich auf einen Rundsteuerempfänger mit mindestens einem digitalen Filter, dessen Frequenzgang an bestimmten Stellen hohe Dämpfungswerte aufweist. Diese Stellen sind so gewählt, daß sie mit bekannten Störfrequenzen im jeweiligen Stromversorgungsnetz übereinstimmen.

Rundsteuerempfänger werden seit Jahrzehnten in Stromversorgungsnetzen zur Steuerung von Verbrauchern eingesetzt. In der Rundsteuertechnik arbeitet man mit codierten Tonfrequenzsignalen, die in Telegrammform gesendet und dem Stromversorgungsnetz (z.B. 50Hz oder 60Hz) überlagert sind. In den Netzen der Energieversorgungsunternehmen (EVU) sind Rundsteuersysteme eingeführt, die sich in der Wahl der Tonfrequenz oder anderer Systemmerkmale, z.B. des Impulsrasters unterscheiden. Aufgabe der Rundsteuerempfänger ist es, über das Stromversorgungsnetz übertragene Impulstelegramme zu detektieren und ggf. bestimmte Schaltfunktionen auszuführen. Ein Rundsteuerempfänger enthält zur Lösung dieser Aufgabe einen Eingangsteil zur Filterung und Formung der empfangenen Impulse, einen Verarbeitungsteil zur Auswertung von Impulstelegrammen und einen Ausgangsteil mit Schaltgeräten.

Die Detektionsaufgabe des Rundsteuerempfängers wird erschwert durch das Vorhandensein von Störgrößen im Empfangssignal, dem Netzsignal. Zu den Störgrößen zählen vor allem Oberschwingungen der Netzfrequenz (Netzharmonische), aber auch die Netzfrequenz selbst. Die Netzspannung variiert bezüglich Frequenz und Amplitude in einem Toleranzbereich; entsprechend auch die Netzharmonischen. Weiterhin stören Steuerfrequenzen benachbarter EVU und sonstige regellose Störungen, die als Rauschen feststellbar sind.

Diese Störgrößen sind der Grund dafür, daß ein bestimmter minimaler Empfangspegel der Tonfrequenzimpulse am Eingang der Rundsteuerempfänger nicht unterschritten werden darf. Die üblichen Rundsteuerempfänger mit einem analogen Bandfilter im Eingangsteil sind für eine minimale tonfrequente Funktionsspannung von etwa 0,5% der Netzspannung ausgelegt. Um diese Empfangsspannung sicherzustellen, sind Rundsteuersender mit hoher Leistung erforderlich. Eine Möglichkeit zur Senkung des erforderlichen Sendepegels würde erhebliche wirtschaftliche Vorteile bringen. Mit analogen Bandfiltern ist jedoch keine wesentliche Senkung des minimalen Sendepegels mehr zu erzielen. Außerdem haben analoge Filter fertigungstechnisch einige Nachteile, da sie frequenzbestimmende Bauteile enthalten, die abgestimmt werden müssen.

Eine weitere wichtige Größe ist die Selektivität des Bandfilters. Durch die bisher erreichbare Selektivität ist der derzeitige Frequenzplan (VDEW-Plan) für Rundsteuerfrequenzen bestimmt. Mit wirtschaftlich vertretbarem Aufwand läßt sich mit analogen Filtern auch bezüglich der Selektivität kein wesentlicher Fortschritt mehr erzielen.

In der DE-C- 27 08 074 wird vorgeschlagen, einen Einchip-Mikrocomputer vorzusehen, der auch zum digitalen Ausfiltern der Rundsteuerimpulse verwendet wird. Damit wird das Ziel verfolgt, durch eine größere Integration den Hardware-Aufwand für einen Rundsteuerempfänger zu reduzieren. Das vorgeschlagene digitale Filter soll jedoch lediglich die Funktionen eines analogen Filters nachbilden. Irgendwelche Hinweise, daß sich mit einem digitalen Filter bessere Filtereigenschaften erzielen lassen und auf welche Weise dieses möglich wäre, sind der Patentschrift nicht zu entnehmen. Auch in der DE-A-23 38 620 ist erwähnt, daß anstelle von analogen Filtern auch Digitalfilter eingesetzt werden können. Einzelheiten zur Gestaltung des Frequenzgangs eines geeigneten Digitalfilters sind nicht beschrieben. Es ist dort ein Abtastfilter vorgeschlagen worden, das als digitaler Bandpaß ausgeführt ist und dessen Durchlassfrequenz durch Variation einer Taktfrequenz gesteuert wird. Außerdem sind dort die grundsätzlichen Möglichkeiten, Filtereigenschaften durch eine Filterkaskade zu verbessern sowie die Abtastfrequenz mittels einer PLL-Schaltung an die Netzfrquenz zu koppeln, bekannt.

Der EP-A-0 105 087 ist ein Digitalfilter für einen Rundsteuerempfänger zu entnehmen, das aus zwei kaskadierbaren rekursiven Filtern zweiter Ordnung besteht, ein sogenanntes IRR-Filter, mit zwei Nullstellen im nahen Bereich der Steuerfrequenz, d.h. der Durchlaßfrequenz. Es ist erwähnt, daß auch Steuerfrequenzen benachbarter Rundsteuerdienste zu den Störfrequenzen zählen. Eine Anregung zum Einsatz von FIR-Filtern, die als solche z.B. aus IEEE Transactions on Communications, Vol. COM-33, No. 10, October 1985, pages 1117 bis 1125 bekannt sind, ist der EP-A-0 105 087 nicht zu entnehmen. In den genannten IEEE Transactions wird über Untersuchungen berichtet, deren Ziel eine Reduzierung des Hardware- und Entwurfaufwands war. Zur Vereinfachung der Multiplikationen werden Filterkoeffizienten +1,0 und -1 vorgeschlagen.

Ausgehend von der EP-A-0 105 087 liegt der Erfindung die Aufgabe zugrunde, einen Rundsteuerempfänger mit einem digitalen Filter zur Filterung von Rundsteuerimpulsen aus einem Netzsignal anzugeben, bei dem Nachteile bisheriger Filter vermieden sind und der insbesondere eine Anpassung des Frequenzgangs des Filters an eine Vielzahl von Störfrequenzen ermöglicht.

Diese Aufgabe wird durch einen Rundsteuerempfänger mit mindestens einem digitalen Filter gelöst, dessen Frequenzgang Nullstellen aufweist zur selektiven Dämpfung von Störfrequenzen, insbesondere der harmonischen Frequenzen der Netzfrequenz und der Steuerfrequenzen benachbarter Rundsteuerdienste, wobei das digitale Filter ein Bandbaß-FIR(Finite Impulse Response)-Filter ist mit einer Impulsantwort

$$g(k) = \begin{cases} c \; \sin(\omega_o kT + \phi), & 0 \leq k \leq N-1 \\ 0 & \text{sonst} \end{cases}$$

worin bedeuten:

g(k) = Impulsantwort oder Filterkoeffizient
c = Konstante
$\omega_o$ = $2\pi f_o$, $f_o$ = Rundsteuerfrequenz
T = $1/f_s$, $f_s$ = Abtastfrequenz
k = 0,1,2,3
$\phi$ = Phasenverschiebung
N = Filterordnung.

Vorteilhafte Ausgestaltungen sind in Unteransprüchen angegeben.

Mit der Erfindung wird vorgeschlagen, im Rundsteuerempfänger ein FIR-Eingangsfilter mit einem speziellen Frequenzgang vorzusehen, nämlich mit einer selektiven hohen Dämpfung einzelner Frequenzen oder kleiner Frequenzbereiche. Ein solches Filter hat eine vorteilhaft kurze Einschwingzeit, jedenfalls eine ausreichend kurze Einschwingzeit. Es läßt sich auf unterschiedliche Weise ausführen, wie in den Patentansprüchen angegeben ist.

Mit einer Ausführung als FIR-Matched-Filter-N.-Ordnung läßt sich ein Filter erreichen, das nachstehend als optimales Filter bezeichnet ist und das vorteilhaft bestimmte Frequenzbereiche mit hoher Dämpfung aufweist. Es können beliebige Störfrequenzen (z.B. fremde Rundsteuerfrequenzen) unterdrückt werden, bzw. störende Frequenzbereiche (z.B. in örtlich begrenzten Netzteilen durch Stromrichteranlagen verursachte Störungen). Die Rundsteuerfrequenz kann beliebig gewählt werden, muß also nicht in einem bestimmten Raster liegen. Außerdem ist die Abtastfrequenz fest, also unabhängig von der Rundsteuerfrequenz und der Netzfrequenz. Das bedeutet, daß keine PLL-Schaltung erforderlich ist, um eine Unterdrückung der Netzfrequenz und ihrer Oberschwingungen auch bei schwankender Netzfrequenz sicherzustellen. Allerdings erfordert das Filter selbst derzeit noch einen relativ hohen Aufwand. Dieser Hardware-Aufwand kann jedoch mit fortschreitender technischer Entwicklung rasch an Bedeutung verlieren.

Mit einem als suboptimal bezeichneten Filter lassen sich die gewünschten Filtereigenschaften bei geringerem Hardware-Aufwand auf andere Weise erreichen, nämlich durch ein Filter, das Nullstellen in einem wählbaren Raster von z.B. 25Hz, $16\frac{2}{3}$ Hz, $8\frac{1}{3}$ Hz oder $4\frac{1}{6}$ Hz aufweist, wodurch sowohl Netzharmonische als auch Rundsteuerfrequenzen anderer EVU im gewählten Raster unterdrückt werden. Dadurch können sich benachbarte EVU bei Benutzung unterschiedlicher Steuerfrequenzen, die einem Vielfachen der gewählten Rasterfrequenz entsprechen, gegenseitig nicht stören. Das bedeutet auch, daß heute übliche Tonfrequenzsperren und Saugkreise in den Versorgungsnetzen nach Einführung des erfindungsgemäßen Empfängers entfallen können. Es können zusätzlich solche Steuerfrequenzen benutzt werden, die bisher wegen dicht benachbarter Harmonischer der Netzfrequenz nicht verwendbar waren. Und ein sehr wesentlicher Vorteil ist schließlich, daß für die Rundsteuerfrequenz minimale Empfangspegel von etwa 0,1 bis 0,3% der Netzspannung ausreichend sind.

Durch geeignete Wahl der Filterkoeffizienten kann der Realisierungsaufwand für das suboptimale digitale Filter gering gehalten werden. Hierfür kommen Filterkoeffizienten in Betracht, die sich aus Potenzen der Zahl 2 zusammensetzen. Diese Möglichkeit ist bekannt aus E. Lüder, "Design and Optimization of Digital Filters without Multipliers", AEÜ, Band 37(1983), Heft 9/10 Seite 299 bis 302, insbesondere Seite 299, Gleichung (3). Nach einer vorteilhaften Ausgestaltung der vorliegenden Erfindung wird vorgeschlagen, eine Übertragungsfunktion mit solchen Parametern zugrundezulegen, daß die Filterkoeffizienten nur die Werte -1, 0 oder 1 annehmen. Damit sind zur Realisierung des Filters lediglich Additionen und Subtraktionen erforderlich, wodurch das Rechenverfahren stark vereinfacht wird. Vorteilhaft ist auch die Möglichkeit der Verwendung einer rekursiven Filterstruktur zur Realisierung des Filters.

Mit Hilfe einer PLL-Schaltung kann vorteilhaft eine Kopplung der Abtastfrequenz an die Netzfrequenz erreicht werden. Dadurch wird vermieden, daß sich die Filtereigenschaften mit Schwankungen der Netzfrequenz ändern.

Die Erfindung wird anhand von Ausführungsbeispielen und der Zeichnung näher erläutert.

Es zeigen:

Fig. 1      ein Blockschema eines Rundsteuerempfängers,

Fig. 2      typische Pegelwerte für Netzharmonische nach VDE 0420 sowie Rundsteuerfrequenzen nach VDEW,

Fig. 3      den Dämpfungsverlauf eines optimalen digitalen Filters,

Fig. 4      den Dämpfungsverlauf eines suboptimalen digitalen Filters

Fig. 5      vorteilhafte Filterkoeffizienten g(k).

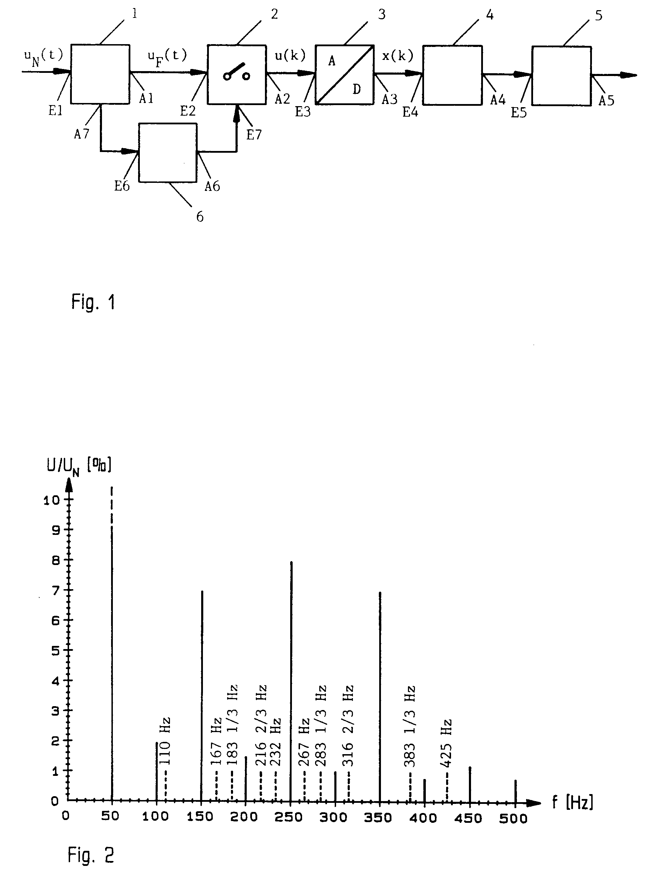

Fig. 1 zeigt ein Blockschema eines erfindungsgemäßen Rundsteuerempfängers. Der Rundsteuerempfänger enthält ein Vorfilter 1, einen idealen Abtaster 2, einen A/D-Wandler 3, eine digitale Verarbeitungseinheit 4 und eine Ausgangsstufe 5, die hintereinander geschaltet sind. Außerdem ist eine PLL-Schaltung 6 vorgesehen, deren Eingang E6 mit einem zweiten Ausgang A7 des Vorfilters 1 und dessen Ausgang A6 mit einem zweiten Eingang E7 des Abtasters 2 verbunden ist. Die digitale Verarbeitungseinheit 4 hat sowohl die Funktion eines Bandfilters zur digitalen Filterung der Rundsteuerimpulse aus dem Netzsignal, als auch die Funktion eines Auswerters. Das Eingangsteil des Rundsteuerempfängers wird also durch die Komponenten Vorfilter 1, Abtaster 2, A/D-Wandler 3 und Bandfilter in der Verarbeitungseinheit 4 gebildet.

Die PLL-Schaltung 6 ist nicht unbedingt erforderlich, ermöglicht jedoch einen besonders niedrigen Sende- bzw. Empfangspegel für die Rundsteuerfrequenz. Durch Kopplung der Abtastfrequenz des Abtasters 2 mit der Netzfrequenz wird dabei erreicht, daß auch bei Schwankungen der Netzfrequenz die Netzharmonischen stark gedämpft werden. Ein Anti-Aliasing-Filter ist entbehrlich.

Bei Verwendung einer PLL-Schaltung, wie in Fig. 1 dargestellt, besteht das Vorfilter 1 aus einem Butterworth-Hochpaß 4. Ordnung mit einer Grenzfrequenz $f_g$ = 150Hz zur selektiven Dämpfung des Netzfrequenzpegels und einem Tiefpaß 1. Ordnung mit $f_g$ = 350Hz. Mit dem Hochpaß wird der Pegel der Netzfrequenz abgesenkt in den Bereich der übrigen Signalkomponenten, und außerdem eine Anpassung des Netzsignalpegels an einen für die nachgeschalteten elektronischen Einrichtungen zulässigen Spannungsbereich erreicht. Mit dem Tiefpaß werden hochfrequente Störungen, z.B. durch Schaltvorgänge, sowie Geräuschpegel gedämpft. Der Ausgang des Tiefpasses ist auf den Ausgang A7 des Vorfilters 1 geführt, an den die PLL-Schaltung 6 angeschlossen ist.

Wenn auf eine PLL-Schaltung verzichtet, also mit fester Abtastfrequenz gearbeitet wird, ist im Vorfilter 1 anstelle des einfachen Tiefpasses 1. Ordnung ein Tiefpaß 6. Ordnung mit einer Grenzfrequenz $f_g$ = 350Hz zweckmäßig. Der Tiefpaß 6. Ordnung wirkt als Anti-Aliasing-Filter, wirkt also einer Verfälschung des analogen Spektrums durch die anschließende Abtastung entgegen.

Einem Eingang E1 des Vorfilters 1 wird das Netzsignal $u_N(t)$ zugeführt. An einen Ausgang A1 des Vorfilters wird ein vorgefiltertes und im Pegel angepaßtes Signal $u_F(t)$ abgegeben an einen Eingang E2 des idealen Abtasters 2. Der ideale Abtaster 2 bildet durch äquidistante Abtastung mit einer Abtastzeit T aus dem kontinuierlichen Signal $u_F(t)$ eine diskrete Wertefolge u(k). Der anschließende A/D-Wandler 3 bewirkt eine Amplituden-Quantisierung der Wertefolge u(k) und gibt an seinen Ausgang A3 eine Wertefolge ab, die als Eingangsfolge x(k) einem Eingang E4 der digitalen Verarbeitungseinheit 4 zugeführt ist.

Mit der digitalen Verarbeitungseinheit 4 ist ein digitales Bandfilter realisiert sowie eine Auswerteeinrichtung zur Decodierung der empfangenen Rundsteuerimpulse. Die Decodierung von Rundsteuerimpulsen sowie auch die Ausführung des Ausgangsteils 5 ist bekannt und bedarf keiner weiteren Erläuterung. Die nachstehenden Ausführungen beziehen sich deshalb auf die Konzeption des digitalen Bandfilters.

Bei der Konzeption des Bandfilters geht man aus von einem bekannten oder ermittelten Frequenzspektrum, das beispielsweise in Fig. 2 dargestellt ist. Fig. 2 zeigt Pegelwerte U in Prozent der Netzspannung $U_N$ für Netzharmonische nach VDE 0420 (durchgezogene Linien) und Steuerfrequenzen von Rundsteuersystemen (gestrichelte Linien), wobei Rundsteuerfrequenzen nach VDEW mit einem Pegel von 1% der Netzspannung angegeben sind. Ein optimales Filter braucht - damit eine endliche Einschwingzeit erreicht wird - nur in dem schmalen Bereich der störenden Netzharmonischen und fremden Rundsteuerfrequenzen einen hohen Dämpfungswert aufzuweisen. In den dazwischenliegenden Frequenzbereichen genügt eine geringere Dämpfung zur Unterdrückung von Rauschen oder sonstiger Störungen im Netz. Die Netzharmonischen sind nicht als Spektrallinien, sondern als kleine Frequenzbereiche anzusehen, weil sich die Netzfrequenz in einem zulässigen Toleranzbereich von z.B. 49 bis 50,5Hz bewegt und damit auch die Netzharmonischen nicht konstant sind. Außerdem weisen auch die Rundsteuerfrequenzen einen Toleranzbereich auf.

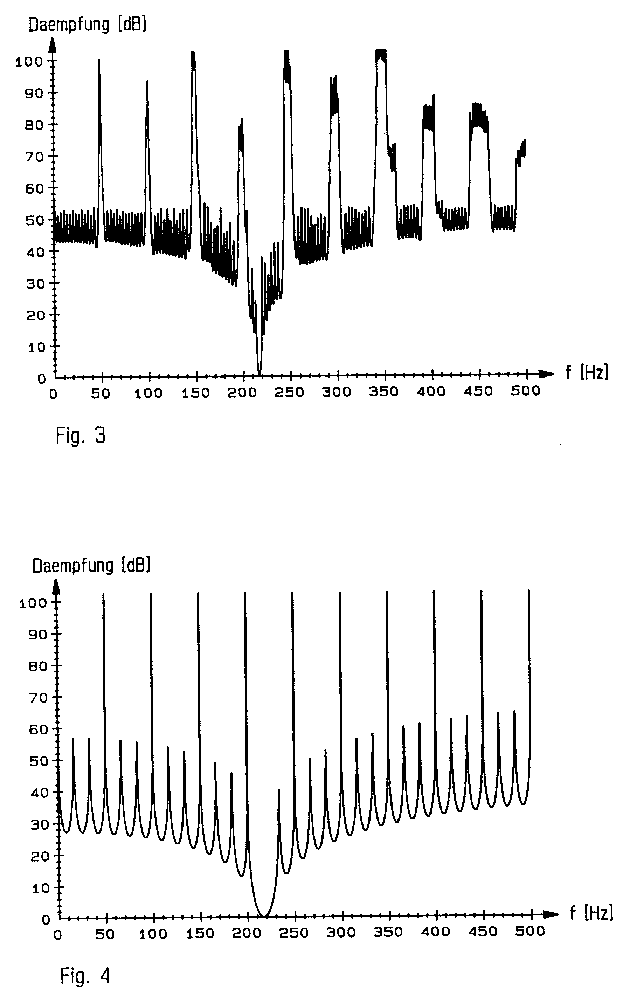

Der Dämpfungsverlauf eines als optimal anzusehenden Filters, das bei den gegebenen Bedingungen am Ausgang ein maximales Leistungsverhältnis zwischen Nutz- und Störsignal liefert (Matched-Filter), ist in Fig. 3 beispielhaft dargestellt. Im dargestellten Beispiel wurden jedoch fremde Rundsteuerfrequenzen nicht berücksichtigt.

Ein solches Filter wäre als Analogfilter nicht realisierbar. Auch eine Ausführung als Digitalfilter erfordert einen gewissen Hardware-Aufwand, da eine hohe Filterordnung und damit eine hohe Anzahl von Multiplikationen und Additionen pro Abtastzeit erforderlich ist. Jedoch kann bei einem solchen optimalen Filter ein Eingangspegel für die Rundsteuerfrequenz von etwa 0,1% der Netzspannung ausreichen und zwar im gesamten Toleranzbereich der Netzspannung und ihrer Harmonischen. Der erforderliche Empfangspegel ist abhängig von der geforderten Bitfehlerwahrscheinlichkeit.

Mit der Erfindung wird vorgeschlagen, ein sogenanntes suboptimales Filter vorzusehen, das einen etwa gleich niedrigen Empfangspegel ermöglicht und einfacher realisierbar ist. Dabei geht man von einem digitalen Bandfilter aus mit der Impulsantwort

$$g(k) = \begin{cases} c \ \sin(\omega_o kT + \phi), & 0 \leq k \leq N-1 \\ 0 & \text{sonst} \end{cases}$$

worin bedeuten:

$g(k) =$ Impulsantwort oder Filterkoeffizient
$c =$ Konstante
$\omega_o =$ $2\pi f_o$, $f_o =$ Rundsteuerfrequenz
$T =$ $1/f_s$, $f_s =$ Abtastfrequenz
$k =$ $0,1,2,3$
$\phi =$ Phasenverschiebung
$N =$ Filterordnung.

Die Parameter c, T und $\phi$ sind so gewählt, daß sich einfache Filterkoeffizienten g(k) ergeben, nämlich lediglich die Werte -1, 0 oder 1. Für den Zusammenhang zwischen Eingangsfolge x(k) und Ausgangsgröße y(k) des Filters gilt:

$$y(k) = \sum_{i=0}^{N-1} g(i) \ x(k-i)$$

Mit den einfachen Filterkoeffizienten g(k) = -1, 0 oder 1 sind zur Realisierung des Filters lediglich Additionen und Subtraktionen erforderlich.

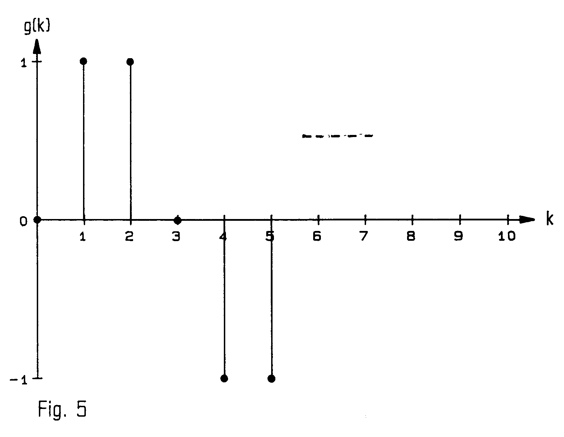

Wählt man beispielsweise die Parameter Abtastfrequenz $f_s = 6f_o$, Konstante $c = 2/\sqrt{3}$ und Phasenverschiebung $\emptyset = 0°$, so ergeben sich die in Fig. 5 dargestellten Filterkoeffizienten g(k) = 0, 1, 1, 0, -1, -1, ....

Eine weitere günstige Eigenschaft des vorgeschlagenen suboptimalen Filtertyps ist die Möglichkeit der Verwendung einer rekursiven Filterstruktur zur Realisierung des Filters. Dadurch ist eine weitere Reduktion des Aufwands möglich. Im Falle der Filterkoeffizienten g(k) = 0, 1, 1, 0, -1, -1, ... erhält man die Differenzengleichung

y(k) = y(k-1) - y(k-2) + x(k-1) - x(k-N-1).

Zur Berechnung der Ausgangsgröße y(k) sind unabhängig von der Filterordnung N lediglich zwei Subtraktionen und eine Addition erforderlich.

Das angegebene Filter unterdrückt bestimmte Frequenzen $f_k$ völlig durch Nullstellen im Amplitudengang. Für diese Frequenzen gilt

$$f_k = \frac{k}{N} f_s \qquad\qquad k = 0,1,\ldots, N-1$$
$$k \neq \frac{N}{6}, \ \frac{5}{6}N$$

Diese Eigenschaft des Filters wird zur Elimination der Netzfrequenz und ihrer Oberwellen ausgenutzt. Dies geschieht durch geeignete Wahl der Abtastfrequenz $f_s$ und der Filterordnung N.

Für eine typische Rundsteuerfrequenz $f_o$ = $216^2/_3$ Hz ergibt sich die Abtastfrequenz $f_s$ zu

$f_s$ = 6 $f_o$ = 1300Hz.

Eine Unterdrückung der Netzfrequenz $f_N$ = 50Hz einschließlich sämtlicher Oberwellen erfolgt bei den Filterordnungen:

N = 78, 156, 234, 312, 390,...

Bei diesen Filterordnungen N erfolgt zudem eine vollständige Unterdrückung fremder Steuerfrequenzen im $16^2/_3$ Hz-Raster. Es ist leicht einzusehen, daß durch entsprechende Parameterwahl auch eine Unterdrückung von Steuerfrequenzen in einem anderen Raster erreicht werden kann, z.B. in $8^1/_3$ Hz- oder $4^1/_6$ Hz-Raster.

Fig. 4 zeigt den Dämpfungsverlauf eines suboptimalen Filters im Falle der Filterordnung N = 78. Ein solches Filter hat eine kurze Einschwingzeit (ca. 60ms).

Durch Reihenschaltung von zwei oder mehr Filtern erhält man eine noch größere Variabilität bezüglich des Dämpfungsverlaufs und bei Frequenzabweichung ähnlich günstige Ergebnisse wie durch Verwendung einer PLL-Schaltung.

Es wurden umfangreiche Testreihen mit einem optimalen und einem suboptimalen Digitalfilter in einem EVU-Netz durchgeführt, wobei die theoretisch zu erwartenden Ergebnisse praktisch bestätigt wurden. Dabei wurde auch gezeigt, daß das vorgeschlagene suboptimale Filter für Rundsteuerempfänger z.B. mit einem 8Bit-Mikroprozessor vom Typ Intel 8085 realisiert werden kann und daß damit ausgerüstete Rundsteuerempfänger im praktischen Betrieb etwa gleich günstige Eigenschaften wie Rundsteuerempfänger mit einem optimalen Filter aufweisen.

**Patentansprüche**

1. Rundsteuerempfänger mit mindestens einem digitalen Filter (4), dessen Frequenzgang Nullstellen aufweist zur selektiven Dämpfung von Störfrequenzen, insbesondere der harmonischen Frequenzen der Netzfrequenz und der Steuerfrequenzen benachbarter Rundsteuerdienste, dadurch gekennzeichnet, daß das digitale Filter ein Bandpaß-FIR(Finite Impulse Response)-Filter ist mit einer Impulsantwort

$$g(k) = \begin{cases} c \ \sin(\omega_o kT + \phi), & 0 \leq k \leq N-1 \\ 0 & \text{sonst} \end{cases}$$

worin bedeuten:

g(k) = Impulsantwort oder Filterkoeffizient
c = Konstante
$\omega_o$ = 2 $\pi$ $f_o$, $f_o$ = Rundsteuerfrequenz
T = $^1/f_s$, $f_s$ = Abtastfrequenz
k = 0,1,2,3
$\phi$ = Phasenverschiebung
N = Filterordnung.

2. Rundsteuerempfänger nach Anspruch 1, dadurch gekennzeichnet, daß das Bandpaß-FIR-Filter als Reihenschaltung von zwei FIR-Filtern aufgebaut ist.

3. Rundsteuerempfänger nach Anspruch 1 oder 2, dadurch gekennzeichnet, daß die Abtastfrequenz ($f_s$) des digitalen Filters mittels einer phasensynchronisierten Regelschleife (PLL-Schaltung) an die Netzfrequenz ($f_N$) gekoppelt ist.

4. Rundsteuerempfänger nach einem der vorstehenden Ansprüche, dadurch gekennzeichnet, daß die Filterparameter Abtastfreqenz ($f_s$), Konstante (c) und Phasenverschiebung ($\phi$) in solcher Weise gewählt sind, daß sich nur Filterkoeffizienten g(k) = -1, 0 oder 1 ergeben.

5. Rundsteuerempfänger nach einem der vorstehenden Ansprüche, dadurch gekennzeichnet, daß die Filterordnung (N) so gewählt ist, daß sich Nullstellen im Abstand $\Delta f$ = Netzfrequenz $f_N/m$ ergeben, wobei m = 1, 2, 3, ... ist, und die Antastfrequenz ($f_s$) ein ganzzahliges Vielfaches der Netzfrequenz ($f_N$) ist.

6. Rundsteuerempfänger nach einem der vorstehenden Ansprüche, dadurch gekennzeichnet, daß zur Realisierung eine rekursive Filterstruktur vorgesehen ist.

**Claims**

1. Ripple-control receiver having at least one digital filter (4), the frequency response of which exhibits null for the selective attenuation of interference frequencies, particularly the harmonic frequencies of the system frequency and the control frequencies of adjacent ripple-control services, characterised in that the digital filter is a band-pass FIR (Finite Impulse Response) Filter having an impulse response

$$g(k) = \begin{cases} c \sin(\omega_o kT + \phi), & 0 \le k \le N-1 \\ 0 & \text{else} \end{cases}$$

where:

g(k) = impulse response or filter coefficient
c = constant
$\omega_o$ = $2\pi f_o$, $f_o$ = ripple-control frequency
T = $1/f_s$, $f_s$ = sampling frequency
k = 0,1,2,3
$\phi$ = phase shift
N = filter order.

2. Ripple-control receiver according to Claim 1, characterized in that the band-pass FIR filter is constructed as a series circuit of two FIR filters.

3. Ripple-control receiver according to Claim 1 or 2, characterized in that the sampling frequency ($f_s$) of the digital filter is coupled to the system frequency ($f_N$) by means of a phase-synchronized control loop (PLL circuit).

4. Ripple-control receiver according to one of the preceding claims, characterized in that the filter parameters of sampling frequency ($f_s$), constant (c) and phase shift ($\phi$) are selected in such a manner that only filter coefficients g(k) = -1, 0 or 1 are obtained.

5. Ripple-control receiver according to one of the preceding claims, characterized in that the filter order (N) is selected in such a manner that null are obtained at intervals of $\Delta f$ = system frequency $f_N/m$, where m = 1, 2, 3, ... and the sampling frequency ($f_s$) is an integral multiple of the system frequency ($f_N$).

6. Ripple-control receiver according to one of the preceding claims, characterized in that a recursive filter structure is provided for the implementation.

**Revendications**

1. Récepteur de télécommande centralisée comprenant au moins un filtre numérique (4) dont la courbe de réponse présente des points zéro pour l'affaiblissement sélectif de fréquences perturbatrices, en particulier des fréquences harmoniques de la fréquence du réseau et des fréquences pilotes de services voisins de télécommande centralisée, caractérisé en ce que le filtre numérique est un passe-bande FIR (Finite Impulse response) avec une réponse par impulsions

7

$$g(k) = \begin{cases} c \ \sin(\omega_o kT + \phi), & 0 \leq k \leq N-1 \\ \\ o & \text{autre} \end{cases}$$

où :

g(k) = réponse par impulsions ou coefficient de filtre

c = constante

$\omega_o$ = 2 $\pi$ $f_o$, $f_o$ = fréquence de télécommande centralisée

T = 1/$f_s$, $f_s$ = fréquence de balayage

k = 0, 1, 2, 3

$\phi$ = déphasage

N = ordre de filtre.

2. Récepteur de télécommande centralisée selon la revendication 1, caractérisé en ce que le passe-bande FIR est composé de deux filtres FIR montés en série.

3. Récepteur de télécommande centralisée selon la revendication 1 ou 2, caractérisé en ce que la fréquence de balayage ($f_s$) du filtre numérique est couplée à la fréquence du réseau ($f_N$) au moyen d'une boucle de régulation (circuit PLL) à phases synchronisées.

4. Récepteur de télécommande centralisée selon l'une des revendications précédentes, caractérisé en ce que les paramètres du filtre, à savoir fréquence de balayage ($f_s$), constante (c) et déphasage ($\phi$), sont choisis de manière à obtenir uniquement des coefficients de filtre g(k) = -1, 0 ou 1.

5. Récepteur de télécommande centralisée selon l'une des revendications précédentes, caractérisé en ce que l'ordre du filtre (N) est choisi de manière à obtenir des points zéro à intervalle $\Delta f$ = fréquence du réseau $f_N$/m, où m = 1, 2, 3, ..., et à ce que la fréquence de balayage ($f_s$) soit un multiple entier de la fréquence du réseau ($f_N$).

6. Récepteur de télécommande centralisée selon l'une des revendications précédentes, caractérisé en ce que pour la réalisation, il est prévu une structure de filtre récurrente.

Fig. 1

Fig. 2

Fig. 3

Fig. 4

Fig. 5